# EUROPEAN PATENT APPLICATION

(11) **EP 3 065 164 A1**
(43) Date of publication of application: **07.09.2016**
(21) Application number: 15157572.7
(22) Date of filing: 04.03.2015
(51) Int. Cl.: H01L 21/56, H01L 23/31, H01L 25/07, H01L 23/485

(54) **Power semiconductor arrangement and method of generating a power semiconductor arrangement**

(71) Applicant: ABB Technology AG, 8050 Zürich (CH)
(72) Inventor: Schuderer, Jürgen, 8047 Zürich (CH); Mohn, Fabian, 5408 Ennetbaden (CH); Vemulapati, Umamaheswara, 5430 Wettingen (CH)
(74) Representative: ABB Patent Attorneys

(57) **Abstract**

The present invention relates to a power semiconductor arrangement (10), comprising a power semiconductor device (12) having a top side (14) and having a back side (16), the back side (16) being arranged opposite to the top side (14), wherein the power semiconductor device (12) comprises at least one electrical contact (18) at its top side (14), wherein a passivation layer (20) is provided, the passivation layer (20) being located on at least a part of the top side (14) of the power semiconductor device (12), wherein the passivation layer (20) covers at least one top side edge termination (22, 24) of the top surface of the power semiconductor device (12) and wherein the passivation layer (20) is formed as a pre-fabricated member. To summarize, an arrangement (10) as described above may provide an easy and cost-saving measure in order to allow a secure and reliable working behaviour of a power semiconductor device (12) due to effective passivation, or protection, respectively, thereby further allowing a highly flexible arrangement of the components. The passivation layer (20) may thereby allow a secure passivation particularly in a chemical and/or mechanical and/or electrical way.

## Description

### Technical Field

The present invention relates to power semiconductor arrangements. The present invention further relates to power semiconductor modules comprising such an arrangement and to a method of generating a power semiconductor arrangement. The power semiconductor arrangement comprises a power semiconductor device and allows securely protecting the power semiconductor device mechanically, chemically and electrically.

### Background Art

Power semiconductor modules are known in the art. Generally, power semiconductor modules comprise a baseplate and insulating substrates, on which electrical conductors such as metallizations are provided which serve as location for power semiconductor devices, or chips, respectively. Said chips are connected to terminals, such as power and control terminals. The above defined arrangement may be located in a housing which is filled with an insulating gel, such as silicone gel.

Power semiconductor's layout and its passivation are critical design features to protect the entire chip and allow for robust as well as reliable operation. The role of passivation can preferably comprise stabilization of silicon as semiconductor or stabilization of other semiconductor surfaces, creation of sufficient insulation towards the chip exterior, and protection of the entire chip from environmental factors such as contamination, moisture, scratches and further more.

Issues of passivation often represent fatal defects such as unstable device operation caused by changes in film properties, instability, water permeability, permeability of movable ions such as sodium, pinholes and cracks, and metal disconnection, such as of aluminum, or corrosion due to degradation and stress. This is inter alia described in the Toshiba Semiconductor Reliability Handbook, 2011.

A typical passivation stack for high voltage IGBT devices is based on several layers: A first material layer having a few micrometers to saturate dangling bonds and to drain trapped charges, such as semi-insulating polycrystalline silicon (SIPOS), or diamond like carbon (DLC). Further, passivation may comprise an ion barrier material layer, such as silicon nitride (Si₃N₄) and silicon dioxide (SiO₂), and it may comprise a layer of polyimide or further polymers as mechanical protection.

Passivation may be required especially for applications coming in contact with humidity. For example, Zorn et al, 2013 "Feuchtetest mit hoher Spannungsbelastung an Halbleitermodulen", 41. Halbleiter-Kolloquium, Freiburg, 30.10.2012 report on humidity increased junction termination degradation by oxidation of field rings and by electrochemical ion migration.

Known from Gottwald, et al., Increasing packaging density and thermal performance with minimized parasitics for high power inverters, PCIM Europe 2012, 8-10 May, 2012, Nürnberg/Germany, is further an embedding technology, which shall allow forming especially thin modules. Such a technology is based particularly on lead frames having defined cavities, wherein bond wires shall be replaced.

Regarding power applications, wide bandgap semiconductors, for example, show intrinsically higher design E-fields and respective higher junction termination field stresses. This may be an issue, as it is described in Schuderer et al., Packaging SiC Power Semiconductors - Challenges, Technologies and Strategies, 2nd IEEE Workshop on Wide Bandgap Power Devices and Applications, Knoxville, Oct. 2014.

Further, the Cree 10kV diode as reported in David Grider, Mrinal Das, Anant Agarwal, John Palmour, Scott Leslie & John Ostop, Ravisekhar Raju, Michael Schutten, Al Hefner, "10kV/120A SiC DMOSFET Half H-Bridge Power Modules for 1 MVA Solid State Power Substation", IEEE Electric Ship Technologies Symposium - 2011, is designed for an approximately 3 x times higher junction termination E-field as compared to a conventional 6.5kV silicon diode. Reliability issues of silicon carbide device blocking under humidity conditions have also been reported.

WO 2013/144375 further describes applying borosilicate glasses by plasma vapour deposition on a substrate, such as a power semiconductor substrate, wherein the glass-like layer may be structured via lithography. Layer thickness can be as high as 20µm.

Further, the so-called thru-via technology is generally known. It is mainly driven by boosting DRAM memory capacity per unit board area for accelerated data exchange, reduced power consumption, and higher input/output densities when stacking DRAM integrated circuits. Products for thru-silicon via creation have been proven in 300mm manufacturing environment and paths for process improvement and CoO reduction are known. Processes and products in wafer-level thinning are known as reported in through-silicon via technology revolutionizes chips, Electronics Weekly.com as well as in Yole Development, "3D IC & TSV Interconnects 2012 business Update", July 2012, and D. Lu, CP Wong, "Materials for Advanced Packaging", Springer, 2009.

Known from US 6,465,281 B1 is further a semiconductor wafer level package used to encapsulate a device fabricated on a semiconductor substrate wafer before dicing of the wafer into individual chips. A cap wafer may be bonded to the semiconductor substrate using a low temperature frit glass layer as a bonding agent. The frit glass wafer is in direct contact with only a middle part of the device. A hermetical seal is formed by a combination of the semiconductor substrate wafer, a cap wafer and the frit glass layer.

US 2014/0138827 A1 further describes a flip chip package structure in which a redistribution layer (RDL) is disposed on a surface of both a semiconductor chip and one or more lateral extensions of the semiconductor chip surface. One or more electrical connectors such as solder bumps or copper cylinders may be applied to the redistribution layer and an interposer such as a PCB interposer may be connected to the electrical connectors.

However, there is still potential for improving the design of power semiconductor arrangements. In fact, for power semiconductors, several trends, developments and reports give evidence that actual passivation performance is not sufficient especially for environmental challenging applications.

### Disclosure of Invention

It is an object of the present invention to provide a measure which at least partly avoids one of the disadvantages of the prior art. It is particularly an object of the present invention to provide a measure which allows securely protecting a power semiconductor device.

These objects are at least partly solved by a power semiconductor arrangement according to independent claim 1. These objects are further at least partly solved by a power semiconductor module according to claim 10 and by a method for generating a power semiconductor arrangement according to claim 11. Advantageous embodiments are given in the dependent claims.

A power semiconductor arrangement according to the invention comprises a power semiconductor device having a top side and having a back side, the back side being arranged opposite to the top side, wherein the power semiconductor device comprises at least one electrical contact at its top side, wherein a passivation layer is provided, the passivation layer being located on at least a part of the top side of the power semiconductor device, wherein the passivation layer covers at least one top side edge termination of the top surface of the power semiconductor device and wherein the passivation layer is formed from as a pre-fabricated member.

A power semiconductor arrangement as described above allows securely protecting the power semiconductor element especially in case the power semiconductor arrangement is used in a power semiconductor module.

A power semiconductor arrangement particularly shall mean an arrangement comprising one or more power electrical parts, such as a power semiconductor device, which arrangement may form part of a power semiconductor module.

A power semiconductor module according to the present invention shall particularly mean an arrangement which is based on one or more power semiconductor devices and which may preferably be used as a switch or rectifier in power electronics. Non-limiting examples for power semiconductor devices - also referred to as a wafer, die, or chip, respectively - comprise inter alia insulated-gate bipolar transistors (IGBT), metal-oxide-semiconductor field-effect transistors (MOSFET), gate turn-off thyristors (GTO), diodes, or thyristors.

A passivation layer according to the present invention shall further mean a layer, which is designed to protect the power semiconductor device, or die, respectively, and is thus preferably electrically insulating, mechanically stable and may be directly located on the top surface of the power semiconductor device.

In detail, the power semiconductor arrangement according to the invention comprises a power semiconductor device, also referred to as chip or die, respectively, as it is described above. The power semiconductor device may comprise a semiconductor structure as it is generally known in the art. The semiconductor may in an advantageous manner be selected from a material of a group consisting of silicon (Si), silicon carbide (SiC), or Gallium Nitride (GaN). However, the afore-named examples are in no way limiting the present invention.

Especially on top of the respective structure, and thus on the top side of the power semiconductor device, at least one electrical contact is provided. The electrical contact may for example be formed by a metallization, such as an aluminium metallization, as it is generally known in the art. Depending on the structure and the design of the power semiconductor device, only one contact may be provided, or more than one contact may be provided, such as two or more electrical contacts. The electrical contact may be a first and optionally a second main contact of the power semiconductor device, such as an emitter or source and a collector or drain contact of an IGBT or MOSFET as well as control contact such as a gate of an IGBT or MOSFET. Further, at least one contact may be provided at the backside of the power semiconductor device. Such contact may be a collector or drain contact of an IGBT or MOSFET. However, the contacts provided are not strictly limited to the above-named examples.

According to the arrangement as described above, further, a passivation layer is provided, the passivation layer being located on at least a part of the top side of the power semiconductor device, or its top side surface, respectively. Like described above, the passivation layer has as object to protect the power semiconductor device electrically and/or mechanically and/or chemically and in more detail particularly the top side of the power semiconductor device. Therefore, the passivation layer may protect the semiconductor and optionally the metallization and may generally have an extension or a dimension, respectively, which is adapted to the respective requirements.

In particular, an especially effective protection, or passivation, respectively, may be realized in that the passivation layer covers the top surface of the power semiconductor device and may hermetically seal at least a part of the power semiconductor device, or its top surface, respectively. In particular, that part of the power semiconductor device may be hermetically sealed which is located beneath the passivation layer. According to this, in order to hermetically seal the power semiconductor device at least partly, the passivation layer preferably is in direct and close contact to the top surface of the power semiconductor device, preventing substances such as solids, gases or liquids to be introduced between the passivation layer and the power semiconductor device and thus allowing a hermetical sealing of the power semiconductor device.

Regarding the top surface of the power semiconductor device, it may be provided that the top surface is formed of the semiconductor material, such as silicon, and the at least one electrically conductive contact. It may, however, be preferred, that the top surface of the power semiconductor device at least partly comprises silicon dioxide. Silicon dioxide may be advantageous with regard to applying the passivation layer as it will be described down below.

It is further provided that the passivation layer is located covering at least one top side edge termination of top surface of the power semiconductor device. According to this, a top side edge termination is particularly a position of the power semiconductor device at which, at a top view onto the top side of the power semiconductor device, the power semiconductor device or at least one part of the top side surface ends and thus the top side has a border to a flank side of the power semiconductor device. Further, the top surface of the power semiconductor device is particularly that surface which is located opposite to a surface of the power semiconductor device which might be connected to a substrate.

Furthermore, it is provided that the passivation layer is formed as a pre-fabricated member. In other words, the passivation layer is not formed by deposition methods, for example, and is thus not formed on the power semiconductor device, but contrary thereto, the passivation layer is formed beforehand and is applied as a whole to the power semiconductor device. For example, the passivation layer may be formed plate-like. It may be pre-fabricated such, that it might have its final geometry and/or dimensions before fixing it at the top surface of the power semiconductor device.

Such an arrangement as described above may allow a plurality of advantages especially when forming a power semiconductor module therefrom. In particular, a good chemical and mechanical protection may under circumstances be combined with a good electrical insulation including a superb edge passivation, or edge termination passivation, respectively. Due to the fact that a passivation layer is provided like described above, forming a chip-level protection with superior robustness against any contamination, particles and environment is allowed.

In detail, advantages with regard to edge termination passivation may be achieved especially in the field of high-voltage (HV) power semiconductor devices. In fact, for power semiconductors, it was found that edge termination passivation performance according to the prior art may under circumstances be not sufficient for environmental challenging applications. According to the invention, however, improved passivation performance and robustness is achieved. In fact, due to the fact that the passivation layer is located at least at one edge or preferably at all top side edge termination of the power semiconductor device, the electric field strength at the surface of the passivation of the power semiconductor device may be significantly reduced. This is due to the fact that especially edges of power semiconductor devices provide a high-field region around the edge termination, which may negatively influence the working behaviour of a power semiconductor module, for example or which may damage surrounding parts. With this regard, providing the passivation layer at the top side edges of the power semiconductor device, the field strength in the surrounding media may be significantly reduced. In detail, the field strength may be covered in the material of the passivation layer thereby preventing or at least significantly reducing negative effects of the high electric field, particularly in high voltage power applications.

Especially when using a pre-fabricated member as passivation layer, the passivation layer may be adapted to the required properties. It may inter alia have a comparably large thickness which allows adapting the passivation layer to high blocking capabilities. Further, mechanical as well as electrical protection may be significantly improved allowing an especially effective protection.

Apart from that the passivation layer may especially easily have dimensions which extend over the dimension of the power semiconductor device because of which an adaption not only of the thickness but also of the width is achievable without problems.

Therefore, the power semiconductor device may be protected by an effective top side barrier. Due to the fact that the passivation layer hermetically seals at least a part of the power semiconductor device, an effective protection may be provided with regard to moisture, solids or further contamination and further with regard to mechanical influences.

Therefore, an arrangement as described above may allow a high quality working behaviour and further allows a plurality of applications more securely and reliably compared to the prior art.

For example, for operation in humid environments, such as for trains operating in humid countries or in case they enter tunnels, etc., or for subsea applications, the present invention may be advantageous as a hermetic seal of at least a part of the power semiconductor device is provided and furthermore, the appearance of high electrical fields may be significantly reduced.

Therefore, operation in novel or demanding environments may be allowed as well, such as in dielectric liquids, exemplarily for pressure-tolerant subsea converters or liquids for direct immersion cooling.

Further, power semiconductor modules may be produced in a very high quality, as due to the passivation layer as described above, improved robustness against particle contamination of the semiconductor device in production processes may be achieved. The reason for improved performance may be caused by improved hermeticity, improved blocking capability and/or improved passivation thickness. A further reason may be seen in the fact that long range impact of top passivation impurities and contaminants, such as field distortions by metallic particles, may be prevented or at least significantly reduced.

In other words, a very robust chip level protection or package is provided to enable various back-end processes with much reduced process sensitivity and improved yield. For example, in case a sintering process is performed, such as Ag sintering, scratches due to particles at a junction termination during pressure application is avoided. Correspondingly, in case ultrasonic welding or soldering is used, effects of metallic particle contamination is reduced and further it may under circumstances be the case when topside copper or heavy wire bonding is used, the formation of brittle gate oxide below the respective wire bonding welding zone can be avoided or at least significantly reduced.

Further, the application of the passivation layer may be simplified by using a pre-fabricated member. This is due to the fact that respective methods may be easier and may under circumstances further be conducted more smoothly, allowing reducing the danger of damages to occur.

The above advantages may in an especially preferred manner be realized in that the passivation layer is formed of glass, sapphire or silicon. Especially glass has the advantages of excellent dimensional stability, and excellent chemical inertness. Therefore, the mechanical protection of the power semiconductor device is superb regarding a glass substrate. Further, the coefficient of thermal expansion (CTE) of glass matches very well to the coefficients of most usable semiconductor materials, such as silicon, silicon carbide and gallium nitride. Therefore, even in case high temperature changes occur, no significant losses in mechanical stability will occur. Thus, issues of thermo-mechanical fatigue and aging may be avoided. Therefore, a good long-term stability will be reached allowing a reliable working behavior.

Next to the advantageous mechanical and chemical properties, however, glass as passivation layer as well has good electrical properties especially regarding good electrical resistivity. With this regard, especially glass is most preferred as simulations have shown that the intrinsic electrical conductivity at elevated temperature for glass is much lower as compared to silicon. Therefore, especially using glass as well as the further above-named materials, field stresses can be maintained in the passivation, and field stresses at the interface to the semiconductor encapsulation may effectively be reduced.

Apart from that, the above-named materials and under these, especially glass, are available in large panel formats at low costs, allowing the arrangement and consequently the power semiconductor device to be especially cost-saving.

A cost-saving arrangement is thereby applicable independently of the used materials as, comparing with today's passivation stack materials, masks and processes are much easier to perform due to the fact that certain layers may be omitted when focussing on the passivation layer, such as on the glass substrate.

Further, the above substrates allow forming a hermetic and high-strength passivation of high quality insulator by a defect-free, well defined passivation layer. This allows well defined and reliable properties of the passivation layer.

Due to the fact that no polymers are involved in the passivation layer, the arrangement is capable of high-temperature operation without significant problems.

Especially when using the above-defined materials, the passivation layer is suitably robust upon contaminated and uncontrollable environments, such as oils, gases, moisture, and corrosive compounds. This allows providing a low risk for contamination around junction termination due to the fact that manufacturing and sealing is-performed in well-controlled front-end production environment.

Apart from the above, power electronic building blocks are used in a wide field of applications, for example in frequency conversion. Thereby, particularly in the medium to high voltage range, it is a demanding task to integrate the involved semiconductor based circuitry in an economic space, and to simultaneously fulfill the requirements with respect to heat dissipation, i.e. cooling, and safety against both the risk of electric shocks and the problem of partial discharges. This object is solved with an arrangement as described above as a broad range of different designs is allowed by using such an arrangement.

In fact, superior topside integration, such as cooling and insulations may be realized based on an improved technology for contacting. In addition, flexible topside wiring can be enabled by vertical vias and one or more particularly horizontal redistribution layers, like it is described down below.

To summarize, an arrangement as described above may provide an easy and cost-saving measure in order to allow a secure and reliable working behaviour of a power semiconductor device due to effective passivation, or protection, respectively, thereby further allowing a highly flexible arrangement of the components. The passivation layer may thereby allow a secure passivation particularly in a chemical and/or mechanical and/or electrical way.

According to an embodiment, the passivation layer covers substantially the whole top side surface of the power semiconductor device. According to this embodiment, the passivation layer may be applied in an especially easy manner as a single member, such as a plate-like member. Further, substantially the whole surface may be protected by the passivation layer. This allows a very effective protection measure and thus an especially reliable working behavior of the arrangement, for example in a power semiconductor module. With this regard, a passivation layer covering substantially the whole surface of the top side the power semiconductor device shall particularly mean a passivation layer which covers at least 90% of the top side surface of the power semiconductor device, exemplarily covering at least 95% of the top side surface of the power semiconductor device. As an example, the passivation layer may cover the whole top side surface of the power semiconductor device, except the parts of the electrical contact or contacts which are electrically connected. In other words, the passivation layer may extend over the whole top side surface of the power semiconductor device, wherein, however, electrical conductors are allowed to contact the at least one electrical contact and thus are proceeding through the passivation layer.

According to a further embodiment, the passivation layer is formed as a frame. According to this embodiment, effective edge termination passivation like described above may be reached. Further, electrically contacting the at least one electrical contact at the top side of the power semiconductor device is especially easy. In fact, a contact may be realized, for example, by means of bond wires, as it is generally known in the art. This is especially the truth in case the frame is formed as an outer frame, for example covering only the edge terminations of the power semiconductor device, thereby enframing the structure provided on the top side of the power semiconductor device. This embodiment thus combines very good edge termination passivation with an easy and cost-saving formation of the arrangement.

According to a further embodiment, at least one via is located in the passivation layer, the at least one via being filled with an electrically conductive material, wherein the at least one via is located for contacting at least one electrical contact. According to this embodiment, an especially advantageous embodiment of electrically contacting the at least one electrical contact may be provided. This embodiment may be especially preferred in case substantially the whole top side surface of the power semiconductor device is covered by the passivation layer and the electrical contacts are thus covered by the passivation layer. According to this, it may be provided that at least one via is provided for each electrical contact. Therefore, the electrical contacts are not or not fully covered by the passivation layer but by the via, or the electrically conductive material, respectively.

Regarding the formation of a via, this may preferably be realized by wet or DRIE etching. However, further methods may also be possible, such as laser ablation, mechanical drilling, the usage of photo-sensitive glass, or application of electrical discharges. The formation of a via may thereby be realized cost-saving and with techniques known as such as for power electronics applications. Further, a via does not need to have a big aspect ratio, i.e. it does not have to be long and thin, but it may also have a large area cross-section. Therefore, the geometry of the via may be adapted to the respective application without significant problems. Even though not required, using comparably small dimensions of the via, however, could allow a decrease in thermo-mechanical stress at the interface between the material of the passivation layer, such as glass, and the electrical conductor being present in the via.

The via which is provided in the particularly electrically resistive passivation layer is further filled with a material, which is electrically conductive. This shall particularly mean that the respective material having its defined geometry has an electrical conductivity which is sufficient for carrying even high currents even for power applications. With this regard, it shall be provided that the heat generated in the electrical conductor may be dissipated with measures as known for power semiconductor modules.

With regard to the electrical conductive material, it may be especially preferred that the at least one via is filled with copper. Copper has the advantage of good workability so that it may be introduced into the via without significant problems. Apart from that, it has a good electrical conductivity being suitable as well for power applications. Furthermore, the thermal conductivity of copper is comparably high allowing an especially good thermal management of the arrangement. This is especially the truth when using copper in the via together with using glass as passivation layer, as the thermal conductivity of glass is limited but the copper material may significantly improve heat dissipation.

Exemplary and in no way limiting dimensions of a via, such as being filled with copper, may comprise a diameter in the range of ≥ 20µm to ≤ 1000µm, wherein its thickness may protrude through the whole thickness of the passivation layer. However, the dimensions may strongly depend on the electrically conductive material used and the blocking voltage required.

Regarding the via and its electrically conductive material, it may be provided that these elements are introduced into the passivation layer when the passivation layer is arranged on the power semiconductor device, or these elements may be pre-fabricated before arranging the passivation layer on the power semiconductor device.

According to a further embodiment, the passivation layer protrudes at least one edge termination of the power semiconductor device. According to this, there is at least a part of the passivation layer which is located beside the surface of the power semiconductor device, wherein the lower surface of the passivation layer may be not in contact with the power semiconductor device. This embodiment allows an especially effective reduction of electric fields occurring at the outside of the passivation layer. According to this, edge termination passivation is especially effective allowing an especially safe and reliable working behavior even under demanding conditions, such as high humidity.

Exemplarily and in no way limiting, the region of the passivation layer protruding the power semiconductor device may lie in a range of ≥ 30µm to ≤ 2.0mm. Such thicknesses are not or only hardly achievable by the methods of the prior art and further allow superb protection properties, such as in a mechanical as well as in an electrical manner. Further, these dimensions allow an easy adaption to even strong requirements.

Exemplarily, the passivation layer may have a thickness in the range of ≥100µm. Further, the passivation layer may have a thickness in the range of ≤ 2mm, preferably ≤ 1 mm. With this regard and especially in case the passivation layer is formed from glass, a very effective protection may be provided, especially with regard to edge passivation. This embodiment may be especially useful for high voltage power applications. For example, a glass wafer having a thickness of 360µm is already sufficient to reduce the electric field at the interface to the environment, such as gel, oil, etc., by a factor of about 10. This clarifies the effectiveness of edge termination passivation.

Especially by using a passivation layer formed from glass, sapphire or silicon, it is possible to achieve high thickness which may lie in the above-defined range, such as in a range of up to 1 mm, such as up to 700 µm and down to 30µm allowing an excellent barrier against any contamination.

Alternatively or additionally, the passivation layer may be adapted to a desired blocking capability of the respective power semiconductor device. The higher the blocking voltage of the device, the higher the surface electric field can get for a certain edge termination area. Therefore, the passivation layer thickness may be adapted, e.g., may be enlarged, to get sufficient reduction of the electric field at the passivation layer interface to the surrounding encapsulation medium. With this regard, such an adaption may be realized especially effectively when using a pre-fabricated plate-like passivation layer.

For example, the passivation layer may have a thickness in the range of 500µm in case the device has a blocking capability of 5kV and a thickness in the range of 100µm in case the device has a blocking capability of 1 kV. Such thicknesses are well possible when using pre-fabricated passivation layers but are hardly achievable when using techniques according to the prior art.

According to a further embodiment, one passivation layer covers at least two power semiconductor devices. According to this embodiment, the arrangement may be produced especially easy and cost-saving as one pre-fabricated passivation layer may be applied to a plurality of power semiconductor devices in an easy manner. Apart from that, this embodiment combines an easy production method with an effective edge termination passivation as an arrangement at which the passivation layer protrudes at least one edge termination may be formed in an especially easy manner.

According to a further embodiment, the passivation layer is connected to the power semiconductor device by direct bonding. With this regard, direct bonding, such as direct fusion bonding, allows forming an especially close contact between the passivation layer and the surface of the power semiconductor device. Therefore, the hermeticity of the seal generated by applying the passivation layer to the top surface of the power semiconductor device may be especially effective.

The term direct bonding, or fusion bonding, respectively, thereby refers to a method in which in particular a wafer bonding process may be performed without any additional intermediate layers between the top surface of the power semiconductor device and the passivation layer. The bonding process may be based on the formation of chemical bonds between two surfaces of the respective material. This allows an especially dense contact and superb hermeticity. It may thus be preferred that the respective surfaces are sufficiently clean, flat and smooth in order to prevent unbonded areas which may form voids, i.e. interface delaminations. The procedural steps of the direct bonding process of wafers may be divided into wafer preprocessing, such as smoothening, pre-bonding at room temperature and annealing at elevated temperatures as will be explained later with regard to the method.

According to a further embodiment, at least one via is provided such, that an electrical connection of at least one electrical contact of the power semiconductor device is guided to the backside of the passivation layer. This feature is preferably realized such, that at least the ending portion of the electrical connection is guided to the backside of the passivation layer next to the power semiconductor device. According to this embodiment, contacting the respective electrical contact may be realized especially easy and with low requirements regarding space.

With regard to further technical features and advantages of the power semiconductor arrangement it is referred to the description of the power semiconductor module, the method, the figures as well as the description of the figures, and vice versa.

The present invention further relates to a power semiconductor module, comprising at least one power semiconductor arrangement, like it is described in detail.

A power semiconductor module generally comprises a substrate, on which substrate at least one die or power semiconductor device, respectively, is located. The substrate may generally be any substrate known in the art for power semiconductor modules. For example, the substrate may be formed of an insulating material, such as of a ceramic material. As non-limiting examples, the substrate may be formed from aluminium nitride (AlN), silicon nitride (Si₃N₄) or aluminium oxide (Al₂O₃). On the surface of the top side of the substrate, a plurality of circuit paths may be provided like generally known in the art. Such circuit paths may for example be formed from a metallization, such as from a copper metallization. The metal, such as the copper, may be arranged on the substrate by physical or chemical deposition methods, for example, like it is generally known in the art.

In order to generate the power semiconductor module, thus, a die, or power semiconductor device, respectively, is joined to the substrate via its substrate metallization and a terminal foot is joined to the substrate via its substrate metallization.

Further, in order to remove heat generated in the power semiconductor module, or especially in the power semiconductor device, the substrate may be connected to a baseplate and attached to a cooler. The baseplate is often formed from an ignoble metal, such as of copper or AlSiC both of which may be coated with nickel, for example, and may act as a heat sink thereby effectively removing heat form the circuit paths. Further, the substrate may be coated with an ignoble metal, such as copper, at the area where the baseplate is joined to. The baseplate may be soldered to the substrate or the backside of the substrate, respectively.

With regard to the power semiconductor device, the latter is part of a power semiconductor arrangement as described above and thus the power semiconductor module comprises such an arrangement. Thus the power semiconductor arrangement comprises the power semiconductor device having a top side and having a back side, the back side being arranged opposite to the top side, wherein the power semiconductor device comprises at least one electrical contact at its top side, wherein the passivation layer is provided, the passivation layer being located on at least a part of the top side of the power semiconductor device, wherein the passivation layer covers at least one top side edge termination of the top surface of the power semiconductor device and wherein the passivation layer is formed as a pre-fabricated member.

Further components of the power semiconductor module are known as such to the person skilled in the art and not described in detail.

To summarize, power semiconductor module as described above may provide an easy and cost-saving measure in order to allow a secure and reliable working behaviour of a power semiconductor device due to effective passivation, or protection, respectively thereby further allowing a highly flexible arrangement of the components.

With regard to further technical features and advantages of the power semiconductor module it is referred to the description of the power semiconductor arrangement, the method, the figures as well as the description of the figures, and vice versa.

The present invention further relates to a method of generating a power semiconductor arrangement, the method comprising the steps of:
a) providing a power semiconductor device, the power semiconductor device having at least one electrical contact at its top side;
b) optionally planarizing the top side surface of the power semiconductor device; and
c) applying a passivation layer onto the top surface of the power semiconductor device, wherein
d) the passivation layer is applied as a prefabricated member.

The above method may further be a method for generating a power semiconductor module as the arrangement may be part of a power semiconductor module, as it is described before.

The above-defined method allows providing a power semiconductor arrangement and further a module having improved properties.

To summarize, a method as described above may provide an easy and cost-saving measure in order to allow providing a power semiconductor arrangement, or power semiconductor module, showing a secure and reliable working behaviour of a power semiconductor device due to effective passivation, or protection, respectively, thereby further allowing a highly flexible arrangement of the components.

In detail, step a) of the present method comprises the step of providing a power semiconductor device, the power semiconductor device having at least one electrically conductive contact and thus an electrically conductive structure at its top side. Such a semiconductor device is generally well known in the art. Non-limiting examples for power semiconductor devices - also referred to as a wafer, die, or chip, respectively - comprise inter alia insulated-gate bipolar transistors (IGBT), metal-oxide-semiconductor field-effect transistors (MOSFET), gate turn-off thyristors (GTO), diodes, or thyristors.

Said power semiconductor device comprises for example a silicon (Si) and/or silicon carbide (SiC) and/or gallium nitride (GaN) device wafer and an electrically conductive structure at its top side. The electrically conductive structure may be a metallization, such as a copper metallization, as it is generally known in the art. For example, it may be preferred that the metallization has a thickness in a range of ≤ 50µm, preferably of ≤ 10µm and exemplarily of ≥1 µm. However, the metallization may as well be avoided and replaced by one or more thin electrically conductive silicidation layers, such as a layer comprising titanium or nickel silicide (Si/Ti; Si/Ni). Said silicidation layer or said silicidation layers shall preferably be thin and may have a thickness lying in a range of ≤ 5µm, preferably of ≤ 1µm. The lower limit of the thickness may be limited by the procedure which is used for applying the respective layer and further by the electrical conductivity of the respective layer, as it is clear for the person skilled in the art. In case such a layer is formed by doping the silicon, for example, the thickness may be especially low in case the layer at all exceeds the surface of the silicon.

According to optional step e) of the present method, silicon dioxide is applied such, that the top side surface of the power semiconductor device comprises such silicon dioxide, especially before step b). Therefore, silicon dioxide may be applied to the top side of the semiconductor and the electrical contacts provided at the top side of the power semiconductor device. This may be realized by using low pressure chemical vapour deposition (LPCVD) processes or by using plasma-enhanced chemical vapour deposition (PECVD) processes. The layer may be applied having a thickness of approximately 5µm. However, the thickness may vary for example depending on the thickness of the electrically conductive structure being present on the semiconductor. It may be preferred that the whole surface of the power semiconductor device, or wafer, respectively, comprises the silicon dioxide, comprising the electrical conductor, wherein the surface of the applied layer may preferably be flat. In case the electrically conductive layer is rather thick, the silicon dioxide layer as well may have a comparably larger thickness, such as in the range or more than 5µm. However, in case the electrically conductive layer has a small thickness, this may improve planarization. In this case, the silicon dioxide layer as well may have a comparably small thickness, such as in the range of less than 5µm.

With this regard, it is provided that the top surface of the power semiconductor device comprises silicon dioxide.

According to step b) of the present method, the top surface of the power semiconductor device, such as of the applied silicon dioxide layer, is optionally planarized, and it may thus be smoothened and/or polished, respectively. This step may be omitted in case the surface of the silicon dioxide layer has a suitable roughness directly after application. However, in most cases, this step is preferred. Smoothening may be performed by means of grinding, or chemical and/or mechanical polishing. This step may be realized until the surface has a pre-defined surface roughness. For example, planarizing may be conducted until an average roughness Ra according to DIN EN ISO 4287:2010 of 10nm or less is reached. The lower value of roughness may theoretically not be limited. However, the limit may be set by technical measures for performing the smoothening step as all methods have lower limits of achievable roughness.

Such a roughness may be especially preferred with regard to the following step c) of the present method, according to which a passivation layer is applied onto the top side surface of the power semiconductor device. This step is preferably performed such, that a direct contact is achieved which hermitically seals the power semiconductor device, or its top surface, respectively. This, however, may be realized in an especially effective and advantageous manner in case the surface of the power semiconductor device such as the silicon dioxide layer is comparably flat and thus has a limited roughness as described above.

As an example, step c) may be performed by means of a direct bonding process. A pre-formed passivation layer, such as a glass wafer, is brought into contact with the surface of the silicon dioxide layer, or the wafer, respectively, so that intermolecular Van der Waals attractive forces create a weak bonding between the surface materials. This bonding occurs at room temperature without any external forces.

With further annealing at higher temperature, such as above 300°C, covalent bonds are formed. This direct bonding occurs between many silicon based materials between each other or on the one hand and with silicon dioxide (SiO₂) surfaces being most commonly used in microelectronics and applied according to present step c).

Alternatively to this direct wafer bonding, also other wafer-level bonding mechanisms may be used. These are plasma activated direct bonding (direct bonding with hydrophilic surfaces), anodic bonding (field assisted glass sealing), glass frit bonding ("glass soldering" with low melting glass) and adhesive bonding with SU-8 and Benzocyclobuten being most established. In addition, it also possible to use a metal-to-metal bondline (e.g., Cu to Sn/Cu) between two metal sealing rings, which may be provided on the power semiconductor device as well as on the pre-fabricated passivation layer.

A power semiconductor module may be generated from such arrangement by carrying out further steps generally known as such. For example, the arrangement is connected to a substrate which is soldered to a baseplate. Further, terminals may be connected to parts of the metallization. However, as power semiconductor modules are generally well known as such to the person skilled in the art, these steps are not described in detail here.

The method may comprise the further steps of forming at least one via in the passivation layer and filling the at least one via with an electrically conductive material, such as with copper. The via or the vias are formed such, that the at least one electrical contact located on top of the power semiconductor device may be contacted by the electrical conductive material. Further, the via extends through the whole thickness of the passivation layer. Via formation is preferably done by wet or DRIE etching, but also other methods are possible, such as laser ablation, mechanical drilling, photo-sensitive glass, and electrical discharges.

Finally, the passivation layer such as the glass wafer may be metallized. This allows generating an electrically conductive structure in order to contact a plurality of electrical contacts of one or more power semiconductor devices. The metallization may as well be formed from copper.

It may further be preferred that at least one redistribution layer is provided on top of the passivation layer. Such a redistribution layer has the objective to allow a multilayer wiring. This may be realized by laminating a particularly thin dielectric layer over the metallized passivation layer. The redistribution layer enables bonding out from different locations on the chip, making chip-to-chip bonding simpler.

With regard to further technical features and advantages of the method it is referred to the description of the power semiconductor arrangement, the power semiconductor module, the figures as well as the description of the figures, and vice versa.

### Brief Description of Drawings

These and other aspects of the invention will be apparent from and elucidated with reference to the embodiments described hereinafter.

In the drawings:
- Fig. 1: shows an exemplary embodiment of a power semiconductor arrangement according to the invention;
- Fig. 2: shows a further exemplary embodiment of a power semiconductor arrangement according to the invention and
- Fig. 3: shows a further exemplary embodiment of a power semiconductor arrangement according to the invention;
- Fig. 4: shows a further exemplary embodiment of a power semiconductor arrangement according to the invention;
- Fig. 5: shows a further exemplary embodiment of a power semiconductor arrangement according to the invention; and
- Fig. 6: shows a further exemplary embodiment of a power semiconductor arrangement according to the invention.

### Detailed Description of the Invention

Reference will now be made in detail to various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

Within the following description of the drawings, the same reference numbers refer to the same components. Generally, only the differences with respect to the individual embodiments are described. When several identical items or parts appear in a figure, not all of the parts have reference numerals in order to simplify the appearance.

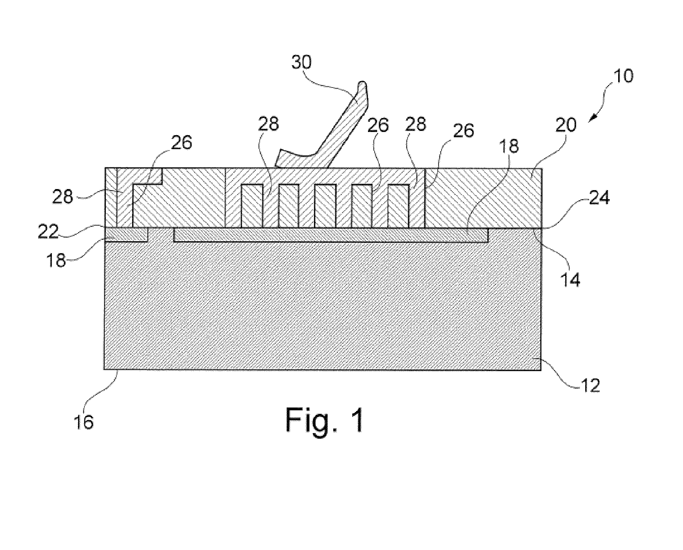

Figure 1 shows an embodiment of a power semiconductor arrangement 10. Such a power semiconductor arrangement 10 may be based on a glass wafer bonded to a silicon device wafer, whereby the glass topside is metallized such that an enhanced clearance distance between topside metallization to the HV semiconductor edge 24 is achieved.

In detail, the power semiconductor arrangement 10 comprises a power semiconductor device 12 having a top side 14 and having a back side 16, the back side 16 being arranged opposite to the top side 14, wherein the power semiconductor device 12 comprises at least one electrical contact 18 at its top side 14. The electrical contact 18 may be comprised by a structure of a metallization, for example, which in turn may form a plurality of contacts 18. Further, a passivation layer 20 is provided, being located on the top side 14 and hermetically sealing at least a part of the power semiconductor device 12 or its top side surface, respectively, wherein the passivation layer 20 is located covering at least one top side edge termination 22, 24 of the power semiconductor device 12. The passivation layer 20 may be formed from a material selected form the group consisting of glass, sapphire and silicon and is formed as a pre-fabricated, particularly plate-like member.

It can further be seen that the passivation layer 20 covers substantially the whole surface of the power semiconductor device 12, or its top side surface, respectively. With this regard, the electrical contact 18 may, in the sense of the present invention, be part of the power semiconductor device 12. In order to electrically connect the electrical contacts 18, a plurality of vias 26 is located in the passivation layer 20, the vias 26 being filled with an electrically conductive material 28, such as copper. The vias 26, or the electrically conductive material 28 located therein, may be contacted by a copper wire 30, for example and/or it may further form an electrically conductive structure at the top of the passivation layer 20. Such an embodiment may be realized by wafer to wafer bonding technology.

The vias 26 may have a diameter of approximately 30µm up to > 1000µm and may have a length corresponding to the thickness of the passivation layer 20.

Even though the thermal conductivity of glass is around 1.1 W/mK, compared to 150W/mK for silicon, for example, however, this value is still a factor 3 better than silicone gel and comes at a superior dielectric performance. For example, a glass material as passivation layer 20 like described above for power semiconductor devices 12 may be specified for a breakdown strength of 217kV/mm for a 500µm wafer. This is an order of magnitude higher than polymeric insulators, which means that the thermal resistance (Rth) for topside cooling can be significantly reduced since thin insulation layers are sufficient. In addition, copper filled vias 26 help to transport heat to a topside cooler, for example.

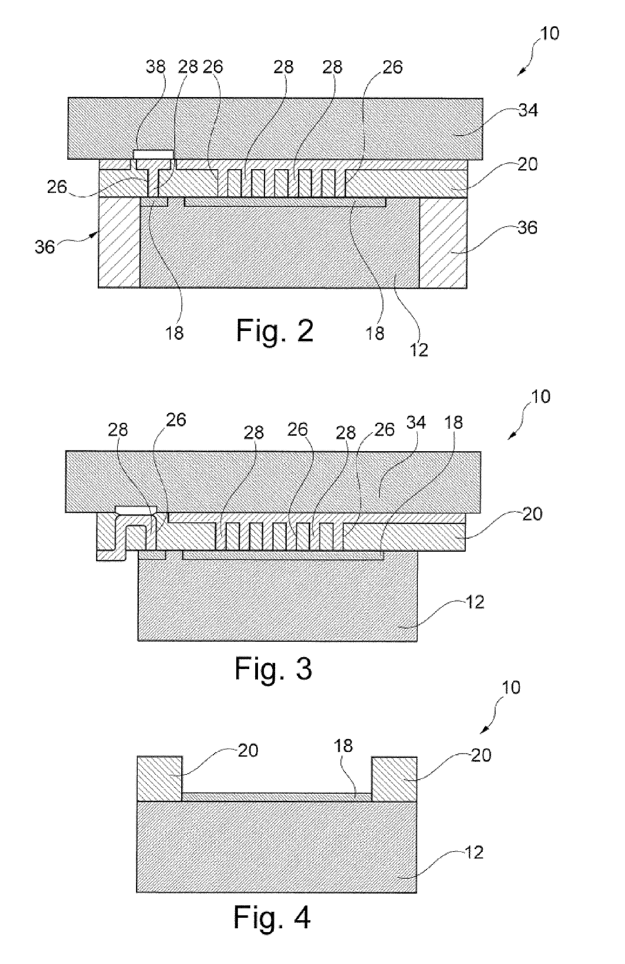

In figure 2, a further embodiment of a power semiconductor arrangement 10 is schematically shown. Such an embodiment, again, is producible by wafer to wafer bonding and is further applied with some device-periphery area not used for device function. It further comprises a planar electrical contact or cooler 34, such as a heat spreader, which is connected to the top side of the passivation layer 20. Apart from that, the power semiconductor device 12 is located beneath a glass wafer as passivation layer 20. The power semiconductor device 12 and the glass wafer may be sawed and isolated together. Further, a channel 38 for introducing gate lead is provided. Apart from that, a material 36 is shown, which can be the wafer base material isolated from the device by some channel stopper doping region, or can be an electrically insulating material, such as silicon dioxide.

Figure 3 shows a further embodiment of a power semiconductor arrangement 10. Such an embodiment is producible based on die-to-wafer bonding and gate-less topside, which appears to be ideal for flip-chip attach. In the embodiment according to figure 3, an electrical contact is routed to the backside. In other words, at least one via 26 is provided such, that an electrical connection of at least one electrical contact 18 of the power semiconductor device 12 is guided to the backside of the passivation layer 20. This embodiment allows especially easy contacting the respective contact, such as the gate contact.

Figure 4 shows a further embodiment of a power semiconductor arrangement 10. The embodiment according to figure 4 shows a power semiconductor device 12 which comprises a passivation layer 20 which is formed as a glass frame, such as of glass frit material. It may be provided that either the frame or, for example in further described embodiments, a full wafer, is direct bonded or attached to the power semiconductor device 12 by glass frit bonding.

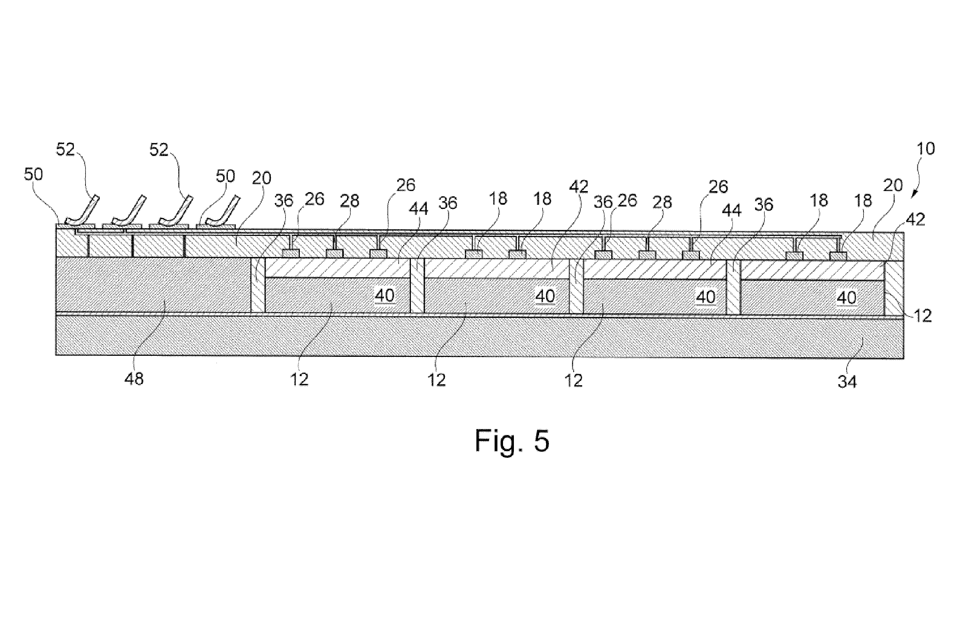

Figure 5 shows a further embodiment of a power semiconductor arrangement 10. The embodiment according to figure 5 is based on wafer-to-wafer bonding for monolithic integration into a single chip converter allowing advanced monolithic integration of lateral gallium nitride devices including control logic into a single chip converter. Since almost all bonding interfaces are omitted, this kind of approach can provide very good high-temperature performance at very high level of integration.

In detail, a plurality of power semiconductor devices 12, respectively comprising a silicon layer 40 and a gallium nitride diode 42 or gallium nitride switch 44 there above, are connected to a common cooler 34, such as a heat spreader. The respective power semiconductor devices 12 are insulated against each other by providing an electrically insulating material 36, such as silicon dioxide there between.

The power semiconductor devices 12 are provided with one common passivation layer 20, wherein the passivation layer 20 protrudes edge terminations of the respective power semiconductor devices 12.

Again, vias 26 are provided which are filled with an electrically conductive material 28, such as copper, in order to connect the respective contacts 18. In order to control the power semiconductor arrangement 10, especially in case it forms a power semiconductor module, a control logic 48 is provided connected to the power semiconductor arrangements 10. The respective power semiconductor devices 12 as well as the control logic 48 may be connected to each other and/or to electrical contacts 50 via a respective electrically conductive structure. At the top or above the passivation layer 20. Exemplarily, such an electrically conductive layer structure may be formed by a redistribution layer. Further, the electrical contacts may be connected by wire bonds 52.

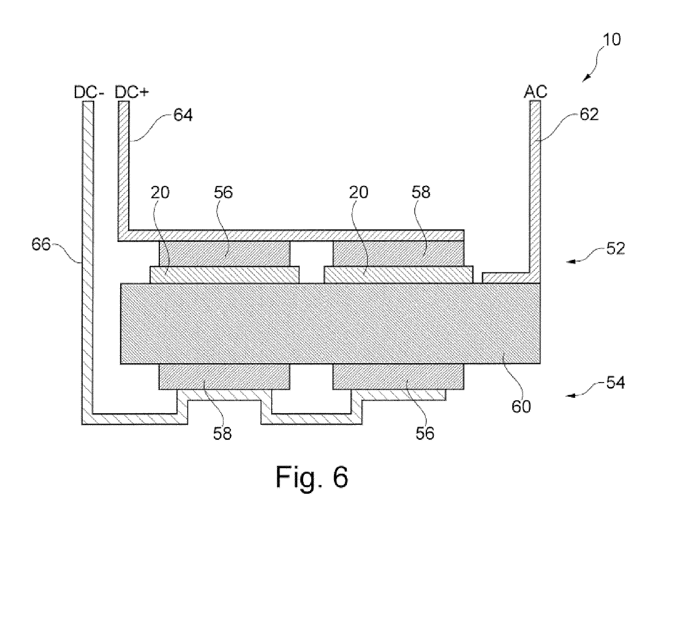

In figure 6, a further embodiment of a power semiconductor arrangement 10 is shown, which arrangement 10 is based on chip stacking and wirebond-less topside interconnection. Such an embodiment allows power module 3D integration by planar topside bonding of the respective power semiconductor devices. This is an advantageous aspect especially with regard to wide bandgap (WBG) power semiconductor modules that preferably are configured in half bridge configurations, like shown in figure 6.

In detail, according to figure 6, the semiconductor arrangement 10 comprises two rows 52, 54 of power semiconductor devices 12, wherein exemplarily two MOSFETs 56 and two diodes 58 are provided as power semiconductor devices 12. The first row 52 of power semiconductor devices 12 is provided in a so-called flip-chip arrangement at which the top side of the devices 12 is connected to an interposer 60 located beneath first row 52 of power semiconductor devices 12 via a passivation layer 20 and above the second row 54 of semiconductor devices. The interposer 60 is designed for electrically connecting the respective power semiconductor devices 12 with each other and with a conductive element 62 in a suitable manner, as it is generally known in the art. Further, the interposer 60 may be provided with a cooling means. Further, conductive elements 62, 64, 66 are provided in order to induce a respective current into the power semiconductor arrangement 10, or the respective power semiconductor devices, respectively, such as alternating current (AC) and direct current (DC+, DC-) as described in figure 6.

According to this configuration, it is especially preferred that a passivation layer 20 having vias 26 not shown as such for connecting the power semiconductor devices 12 like described above is provided as a very flat surface may be provided on the top side of the power semiconductor devices 12 being arranged in the first row 52, which allows an especially preferable flip-chip arrangement.

Therefore, ultra-compact stacked chip arrangement requires flip-chip bonding for one side of the half bridge with issues of heat spreading. The planar glass substrate, for example, as passivation layer 20 allows superior cooling and enables highly compact power modules. The arrangement 10 as described above enables shrinked design and enhanced active area by exploiting high-strength insulation in particular for cost-efficient HV WBG semiconductor devices 12.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 10: power semiconductor arrangement
- 12: power semiconductor device
- 14: top side
- 16: back side
- 18: electrical contact
- 20: passivation layer
- 22: top side edge termination
- 24: top side edge termination
- 26: via
- 28: electrically conductive material
- 30: wire
- 34: cooler
- 36: electrically insulating material
- 38: channel
- 40: silicon layer
- 42: gallium nitride diode
- 44: gallium nitride switch
- 46: silicon oxide layer
- 48: control logic
- 50: electrical contact
- 52: row
- 54: row
- 56: MOSFET
- 58: diode
- 60: interposer
- 62: conductive element
- 64: conductive element
- 66: conductive element

## Claims

1. Power semiconductor arrangement, comprising a power semiconductor device (12) having a top side (14) and having a back side (16), the back side (16) being arranged opposite to the top side (14), wherein the power semiconductor device (12) comprises at least one electrical contact (18) at its top side (14), wherein a passivation layer (20) is provided, the passivation layer (20) being located on at least a part of the top side (14) of the power semiconductor device (12), wherein the passivation layer (20) covers at least one top side edge termination (22, 24) of the top surface of the power semiconductor device (12) and wherein the passivation layer (20) is formed as a pre-fabricated member.

2. Power semiconductor arrangement according to claim 1, wherein the passivation layer (20) covers substantially the whole top side surface of the power semiconductor device (12).

3. Power semiconductor arrangement according to claim 1 or 2, wherein the passivation layer (20) is formed as a frame.

4. Power semiconductor arrangement according to any of the preceding claims, wherein at least one via (26) is located in the passivation layer (20), the at least one via (26) being filled with an electrically conductive material (28), wherein the at least one via (26) is located for contacting at least one electrical contact (18).

5. Power semiconductor arrangement according to claim 4, wherein at least one via (26) is provided such, that an electrical connection of at least one electrical contact (18) of the power semiconductor device (12) is guided to the backside of the passivation layer (20).

6. Power semiconductor arrangement according to any of the preceding claims, wherein the top side surface of the power semiconductor device (12) at least partly comprises silicon dioxide.

7. Power semiconductor arrangement according to any of the preceding claims, wherein the passivation layer (20) protrudes at least one top side edge termination (22, 24) of the power semiconductor device (12).

8. Power semiconductor arrangement according to any of the preceding claims, wherein the passivation layer (20) has a thickness in the range of ≥ 30µm to ≤ 2mm.

9. Power semiconductor arrangement according to any of the preceding claims, wherein one passivation layer (20) covers at least two power semiconductor devices (12).

10. Power semiconductor module, comprising at least one power semiconductor arrangement (10) according to any of the preceding claims.

11. Method of generating a power semiconductor arrangement (10), the method comprising the steps of:
a) providing a power semiconductor device (12), the power semiconductor device (12) having at least one electrical contact (18) at its top side (14);
b) optionally planarizing the top side surface of the power semiconductor device (12); and
c) applying a passivation layer (20) onto the top side surface of the power semiconductor device (12); wherein
d) the passivation layer (20) is applied as a pre-fabricated member.

12. Method according to claim 11, wherein the passivation layer (20) is connected to the power semiconductor device (12) by direct bonding.

13. Method according to claim 11 or 12, wherein silicon dioxide is applied such, that the top side surface of the power semiconductor device (12) comprises such silicon dioxide.

14. Method according to any of claims 11 to 13, wherein the method comprises the further steps of forming at least one via (26) in the passivation layer (20) and filling the at least one via (26) with an electrically conductive material (28).

15. Method according to any of claims 11 to 14, wherein at least one redistribution layer is applied on top of the passivation layer (20).
